# EUROPEAN PATENT APPLICATION

(11) **EP 1 992 460 A2**
(43) Date of publication of application: **19.11.2008**
(21) Application number: 08102384.8
(22) Date of filing: 07.03.2008
(51) Int. Cl.: B26F 1/26, H01L 21/304

(54) **Method for drilling holes on insulators, fabricating optical windows and adjusting angle of optical window circumferential surface and apparatus for drilling holes on insulators and image detection device module**

(30) Priority: 18.05.2007 JP 2007132790
(71) Applicant: He, Yi-Lu, Zhubei City Hsin chu (TW); Yanagisawa, Shintaro, 924 Saitama Niizo (JP)
(72) Inventor: Yanagisawa, Shintaro, 924 Saitama Niizo (JP)
(74) Representative: 2K Patentanwälte Kewitz & Kollegen

(57) **Abstract**

A method and apparatus to fabricate micro-holes on insulators without forming coarse edges on the circumference of the holes includes a protection layer (4) to cover the surface of a targeted object (1) made from an insulator. The protection layer (4) has an opening (40) for hole drilling to receive a solution (2) capable of dissolving the insulator and ejected through a nozzle (3). The solution (2) hits the surface of the targeted object (1) at a pressure between 5X10⁻²N/cm² and 20X10⁻² N/cm². The solution (2) ejected through the nozzle (3) forms particles at diameters between 20µm and 400µm that are smaller than the opening (40) for hole drilling. The hole can be fonned on the targeted object (1) by continuously hitting of the solution (2).

## Description

### FIELD OF THE INVENTION

The present invention relates to a hole drilling technique to form micro-holes on insulators and particularly to a method and apparatus for drilling holes on insulators to fabricate optical windows used on image detection device modules and the like.

### BACKGROUND OF THE INVENTION

Conventional processes to fabricate insulators include operations of shaping, cutting and etching and the like. To fabricate optical windows of precision optical equipments and the like micro-holes have to be formed by drilling on insulators. For instance, image detection device modules used on mobile phones or digital cameras have an optical window on the incident side of a detection element. Light passes through a window opening of the optical window to form a photo image. The optical window is made from an insulator. The window opening is formed at a size slightly larger than the incident surface of the detection element. The detection element generally includes CCDs. By means of micro-fabrication technique condensed objects, namely high resolution (or high pixel) working pieces can be made. The detection element is very small, so is the window opening. This is to meet miniaturizing requirement of the mobile phones and the like.

During fabrication of the miniaturized window opening of the optical window, a micro-hole has to be formed on the insulator through a hole drilling process. To do such a process in practice, such as one used in fabricating LCD elements disclosed in Japan Patent publication No. 61-86729, a sand blasting method may be adopted. Although the sand blasting method also can be used to fabricate the optical window, the circumference of the hole being formed is coarse and uneven. As a result, the aesthetic appeal of the product such as mobile phone suffers. Moreover, the uneven surface causes light scattering and could affect optical characteristics.

### SUMMARY OF THE INVENTION

Therefore the present invention aims to provide a method and apparatus to drill micro-holes on insulators during fabrication of optical windows for image detection device modules and the like without forming uneven circumference of the holes.

The method for drilling holes on insulators according to the invention as specified in Claim 1 aims to drill micro-holes on a targeted object made from an insulator. A solution capable of dissolving the insulator is ejected through a nozzle to form drops or particles at diameters between 20µm and 400µm to be in contact with a selected location of the targeted object. The particulate solution is ejected at a pressure between 5X10⁻²N/cm² and 20X10⁻² N/cm² to continuously hit the selected location to form a through hole thereon.

The present invention also provides a method for fabricating optical windows as specified in Claim 10. The method aims to form an optical window made from an insulator and located on an incident side of an optical element. A solution capable of dissolving the insulator which forms a plate or plank for fabricating the optical window is ejected through a nozzle to form particles at diameters between 20µm and 400µm to be in contact with a selected location of a targeted object. The particulate solution is ejected at a pressure between 5X10⁻²N/cm² and 20X10⁻² N/cm⁻² to continuously hit the selected location to form a through hole thereon to become a window opening.

The present invention further provides a method for adjusting the angle of an optical window circumferential surface as specified in Claim 18. During fabrication of an optical window made from an insulator and located on an incident side of an optical element the optical window circumferential surface forms an included angle with the optical axis that becomes an intended angle. The optical window is formed in a shape with an opening at the incident side greater than another opening at the emission side. The method includes a process to form a protection layer on the surface of a targeted object which forms the optical window, a process to form an opening for hole drilling process on the protection layer and a drilling hole process to dispose a solution capable of dissolving the insulator to reach the targeted object through the opening to form the hole. The process of forming the protection layer aims to cover the surface of the insulator with the protection layer so that the solution does not adhere to insulator surface. The process to form an opening for hole drilling process on the protection layer aims to form the opening smaller than the opening at the incident side. The drilling hole process aims to eject the solution through a nozzle to form particles at diameters between 20µm and 400µm to continuously hit a selected location of the targeted object at a pressure between 5X10⁻²N/cm² and 20X10⁻² N/cm² to form a through hole. In the drilling hole process the hitting pressure and the solution concentration can be adjusted to alter the circumferential angle of the fabricating optical window.

The present invention further provides an apparatus for drilling holes on insulators as specified in Claim 19. The apparatus aims to drill micro-holes on a targeted object made from an insulator. It has a nozzle to eject a solution capable of dissolving the insulator to form particles at diameters between 20µm and 400µm, a solution supply system to supply the solution to the nozzle and a targeted object holding mechanism to hold the targeted object to allow a selected location thereof to receive the solution at a hitting pressure between 5X10⁻²N/cm² and 20X10⁻² N/cm².

The present invention further provides an image detection device module as specified in Claim 24. It includes a module body of a detection element and an optical window made from an insulator and located on an incident side of the detection element. The optical window is formed by forming a hole on a selected location of a plate type material by ejecting a solution capable of dissolving the insulator through a nozzle to form particles at diameters between 20µm and 400µm to continuously hit the plate at a pressure between 5X10⁻²N/cm² and 20X10⁻² N/cm².

According to the invention, as specified in Claim 1, the hole is formed by a chemical reaction of dissolution caused by the solution, thus the circumference of the hole is smooth without forming an uneven surface and is more aesthetic appealing. The window opening of the optical window, as specified in Claim 10, also is formed by a chemical reaction of dissolution caused by the solution, hence it is also more aesthetic appealing and does not have an uneven surface to produce light scattering, and optical characteristics can be maintained intact without creating adverse effect. Based on the apparatus of the invention specified in Claim 19, the hitting pressure and ingredient concentration of the solution can be adjusted to alter the circumferential angle in the range from about 45 degrees to 20 degrees. According to the image detection device module of the invention specified in Claim 24, the window opening of the optical window is formed by a chemical reaction of dissolution caused by the solution, hence it is more aesthetic appealing and does not have an uneven surface to produce light scattering, and optical characteristics can be maintained intact without creating adverse effect.

The foregoing, as well as additional objects, features and advantages of the invention will be more readily apparent from the following detailed description, which proceeds with reference to the accompanying drawings.

### BRIEF DESCRIPTION OF THE DRAWINGS

FIGS. 1A through 1E are schematic views of fabrication processes of a first embodiment of the method of the invention for drilling holes on insulators.
FIG. 2 is a sectional view of a nozzle adopted to FIGS. 1A through 1E.
FIG. 3 is a sectional view of an embodiment of the image detection device module.
FIGS. 4A through 4E are schematic views of embodiments of an optical window adopted for the image detection device module.
FIGS. 5A and 5B are schematic views for adjusting the circumferential angle during hole drilling process.
FIG. 6 is a schematic view of a hole and an opening for hole drilling process to show the relative sizes thereof.
FIGS. 7A and 7B are schematic views of a second embodiment of the method for drilling a hole on an insulator.
FIG. 8 is a schematic view of a first embodiment of the apparatus for drilling holes on insulators.
FIG. 9 is a schematic side view of the first embodiment of the apparatus for drilling holes on insulators.
FIG. 10 is a schematic top view of a nozzle holder adopted on the apparatus shown in FIGS. 8 and 9.
FIGS. 11A through 11C are sectional views for drilling holes on a targeted object through the apparatus shown in FIGS. 8 and 9.
FIG. 12 is a schematic view of a second embodiment of the apparatus for drilling holes on insulators.
FIG. 13 is a schematic side view of the second embodiment of the apparatus for drilling holes on insulators.
FIG. 14 is a schematic view of a third embodiment of the apparatus for drilling holes on insulators.
FIG. 15 is a schematic side view of the third embodiment of the apparatus for drilling holes on insulators.
FIG. 16 is a perspective view of a targeted object holder adopted on the third embodiment.

### DETAILED DESCRIPTION OF THE PREFERRED EMBODIMENTS

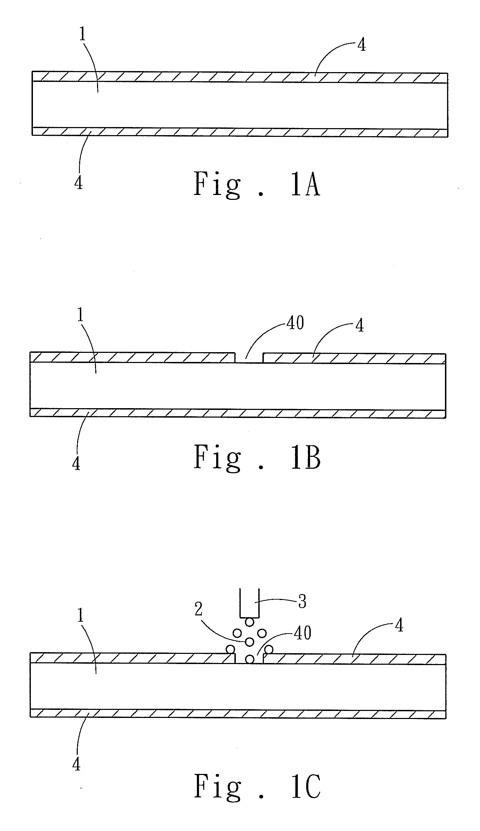

Please refer to FIGS. 1A through 1E for the fabrication processes of a first embodiment of the method of the invention for drilling holes on insulators. The processes aim to drill a circular micro hole 10 at a diameter about 500µm ~ 5mm on a targeted object 1 made from an insulator.

The method provides a main feature that atomizes a solution 2 capable of dissolving an insulator to small particles. The particulate solution 2 is ejected to the surface of the targeted object 1 to perform hole drilling process. The solution 2 may be a strong fluorinate acid diluted with pure water to a selected concentration such as about 3-30% according to the shape of the hole 10 to be formed.

The method set forth above can drill holes on various types of insulators such as those made from silicon borate or the like. According to the material of the insulator a desired solution 2 capable of dissolving the insulator is selected. The solution 2 is atomized to particles at a size capable of forming the hole 10 as desired, preferably within the range between 20µm and 400µm. By means of the method, a chemical reaction is generated to dissolve the insulator through the solution 2 and a physical action is generated by hitting the targeted object 1 with the particulate solution 2. If the particle size of the solution 2 were smaller than 20µm the weight is too small to get an adequate impact pressure. But if the particle size of the solution 2 were greater than 400µm, the impact force is too much and could result in decreasing of the dimensional precision of the hole 10. To form a fine micro-hole also could be difficult. To fabricate the micro hole as desired a suitable nozzle has to be used to eject the particulate solution formed at a size previously discussed.

The solution impact pressure is preferably in the range between 5X10⁻²N/cm² and 20X10⁻² N/cm². If the pressure were less than 5X10⁻²N/cm², the pressure is too small and drilling time is longer, or even becomes too difficult to form the hole as desired. If the pressure were greater than 20X10⁻² N/cm², to form the hole 10 with a desired size and shape could be difficult. Moreover, to eject the particulate solution 2 at a very high pressure to form the hole 10 also has technical problems.

The processes shown in FIGS. 1A through 1E use a nozzle 3 to eject the solution 2 to form particles. Taken into account of the ejecting shape of the solution 2 from the nozzle 3, a process for forming a protection layer 4 to cover the targeted object 1 is included (Referring to FIG. 1A); next, a process to form an opening 40 for hole drilling on the protection layer 4 is executed (referring FIG. 1B); then a hole drilling process can be performed thereinafter (referring to FIGS. 1C through 1E). To drill the hole, the particulate solution 2 has to be concentrated in contact with a selected location (called drilling spot hereinafter) where the hole is to be formed. In addition, using the nozzle 3 according to the embodiment, the ejecting solution 2 will scatter to a larger area around the drilling spot as shown in FIG. 1C. Hence the protection layer 4 is provided to cover the area around the opening 40 for hole drilling and allow the solution 2 to be in contact with only the opening 40 where the hole is to be formed.

The protection layer 4 is resistant to corrosion of the solution 2 (namely medicine-resistance). Namely it does not generate reaction with the solution 2, or cannot be dissolved and consumed by the solution 2. More specifically, in the event that strong fluorinate acid is used as the solution 2, the protection layer can be made of an acid-resistant metal such as chromium, or an acid-resistant resin such as polypropylene (PP).

The protection layer 4 is formed at a thickness without exposing the surface of the targeted object 1 even after the hole drilling process is finished. Namely, even consumed by the solution 2, the protection layer maintains a desired residual thickness until the hole drilling process is finished. When coated with chromium or PP resin as previously discussed, the consumption does not occur hence the protection layer 4 can be made thinner. However, the ability to withstand the physical impact (i.e. mechanical strength) incurred by the ejecting solution 2 also has to be considered. As an example, when the protection layer 4 is made of chromium the thickness is preferably between about 1000 - 3000 A (Angstroms). When the protection layer 4 is made from PP the thickness is preferably between about 30µm~100µm.

While forming the opening 40 for hole drilling is related to the material of the protection layer 4, it also can be performed afterwards through a photolithographic process, or in advance by punching. When the protection layer 4 is made of chromium, the photolithographic process is usually adopted as shown in FIGS. 1A through 1E. In such a case the chromium layer is formed by sputtering at a desired thickness as previously discussed (referring to FIG. 1A), then the opening 40 is formed through the photolithographic process (referring to FIG. 1B). Namely, the protection layer 4 is coated with a photo-resistant agent, and a mask formed with the opening 40 is disposed thereon for exposing, then image developing is performed to form a pattern on the photo-resistant agent with the shape of the opening 40 located thereon. Through the pattern of the photo-resistant agent the chromium layer can be etched as desired to form the opening 40. In some circumstances the photo-resistant agent can also serve as the protection layer 4 (i.e. the material of the photo-resistant agent also is medicine-resistant to the solution 2). Thus through the exposing and image developing processes the opening 40 can be formed. By means of the photolithographic process the opening 40 can be formed precisely. Hence a highly precise hole drilling process can be accomplished in terms of position precision or dimension.

In the event that the protection layer 4 is made from PP resin, a resin film formed at the thickness previously discussed with a preset opening 40 made by punching usually is provided to serve as the protection layer 4 to form the opening 40. The resin film is bonded to the targeted object 1 to position the opening 40 at the drilling spot. Such an approach can bond the resin film closely to the targeted object 1 and can be processed easily through a thermal lamination process. Drilling holes on the resin film may also be accomplished through laser.

Moreover, the protection layer 4 also is preferably to be located on another side of the targeted object 1. For instance, when the targeted object 1 is a plate or plank, the end surfaces thereof are preferably covered by the protection layer 4 as shown in FIGS. 1A through 1E. The other side of the protection layer 4 opposite to the impact side of the solution 2 that is not to be consumed also is covered to prevent the targeted object 1 from being unduly corroded by the scattering or spilling solution 2. Basically, it is preferably to have the entire surface of the targeted object 1 covered by the protection layer 4 with merely the opening 40 for hole drilling exposed.

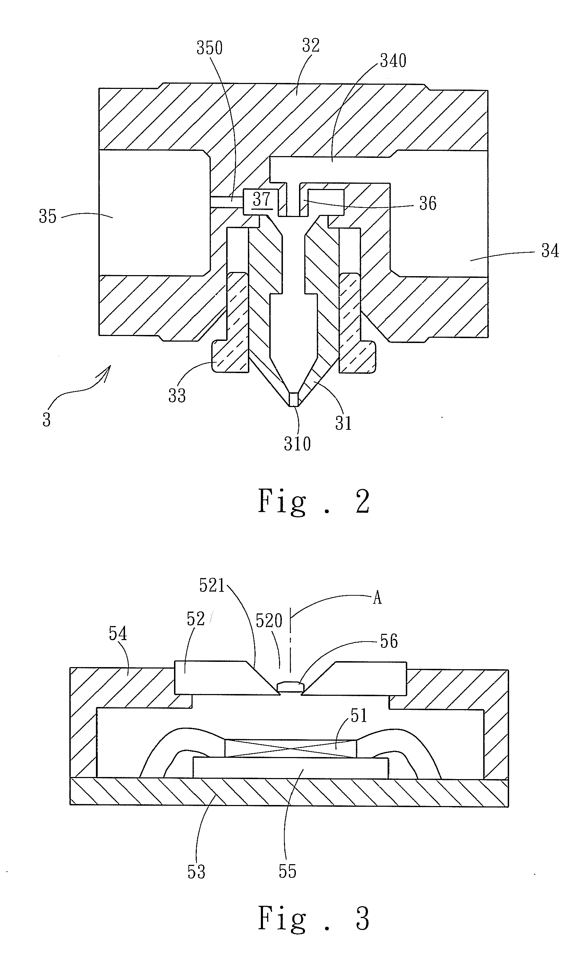

The nozzle 3 used in the processes of FIGS. 1A through 1E aims to eject and atomize the solution 2 to form particles at the diameters between 20µm and 400µm and at the impact pressure between 5X10⁻²N/cm² and 20X10⁻² N/cm². Thus the solution 2 can be ejected in a particulate form to produce impact. FIG. 2 illustrates a nozzle with dual flows. The nozzle 3 shown in FIG. 2 has a nozzle body 31, a connection duct 32 and a fastening ring 33.

The connection duct 32 has a connection portion (called air connector 34 hereinafter) on the right side to hold a compressed air supply tube, and another connection portion (called liquid connector 35 hereinafter) on the left side to hold a solution supply tube. The air connector 34 is wedged in a recess of the compressed air supply tube. The liquid connector 3 is wedged in a recess of the solution supply tube.

The air connector 34 has a transverse air intake tube 340 extended to the center of the connection duct 32. The air intake tube 340 has a pointed end at a lower side to form a protrusive air ejection duct 36 directing downwards.

The connection duct 32 also has a recess 37 (called main recess 37 hereinafter) in the center of a lower surface thereof. The air ejection tube 36 is jutting downwards in the main recess 37 and communicates with the air intake tube 340 and the main recess 37.

Moreover, the liquid connector 35 has a transverse liquid intake port 350 extended to the center of the connection duct 32. The liquid intake port 350 is located at an elevation slightly lower than the air intake tube 340 to reach a side wall of the main recess 37 and communicate with the liquid connector 35 and the main recess 37.

The nozzle body 31 is a barrel which has a passage running through upwards and downwards, and has a lower end wedged in the main recess 37 of the connection duct 32. The nozzle body 31 has an upper end incorporating with the main recess 37 to form a space 30 (called main space 30 hereinafter) surrounding the air ejection duct 36.

Referring to FIG. 2, the passage of the nozzle body 31 is slightly expanded at the upper end, and the air ejection duct 36 has a lower end located in the expanded portion without in contact with the nozzle body 31 but to form a gap therebetween.

The fastening ring 33 is interposed between the main recess 37 and the nozzle body 31, and fasten the nozzle body 31 by screwing to an object where the connector duct 32 is located. The main recess 37 has one side formed with screw threads. The nozzle body 31 has a peripheral surface also formed with screw threads. The fastening ring 33 is engaged with the screw threads set forth above.

Referring to FIG. 2, the nozzle 3 further is connected to the air supply tube and the liquid supply tube to deliver the compressed air and solution 2. The compressed air is supplied through the air intake tube 340 and air ejection duct 36 and ejected into the main space 30. The solution 2 is directed into the main space 30 through the liquid intake port 350. After the solution 2 has filled the main space 30, it flows downwards through the nozzle body 31 and is ejected through a vent 310 (called ejection vent 310 hereinafter) running through the upper end thereof. The compressed air ejected through the air ejection duct 36 is forcefully mixed with the solution 2. While the solution 2 is moved downwards and scattered, it also is ejected through the ejection vent 310. As a result, the solution 2 ejected through the ejection vent 310 is formed in a state of micro particles (atomizing or misting condition). Thus by providing suitable parameters such as the pressure of the compressed air applied to the solution 2, the size of the lower end opening of the air ejection duct 36, the sectional area of the main space 30, the sectional area of the passage running through the nozzle body 31, and the size and shape of the ejection vent 310, the solution 2 with the intended particle size can be ejected at an intended pressure.

The nozzle previously discussed may be fabricated by users or procured on the market. For instance the dual-flow nozzle model 3VVEA made by Ikeuchi corporation is a desired choice.

Various embodiments to implement the method for drilling holes on insulators according to the invention are further elaborated as follow:

As previously discussed, the targeted object 1 is provided with the protection layer 4 and opening 40 for hole drilling formed thereon. Referring to FIG. 1C, the nozzle 3 is located above the targeted object 1 with the ejection vent 310 directing downwards. In such a condition the solution 2 is ejected and scattered, and a portion of the solution 2 passes through the opening 40 to reach and hit the surface of the targeted object 1.

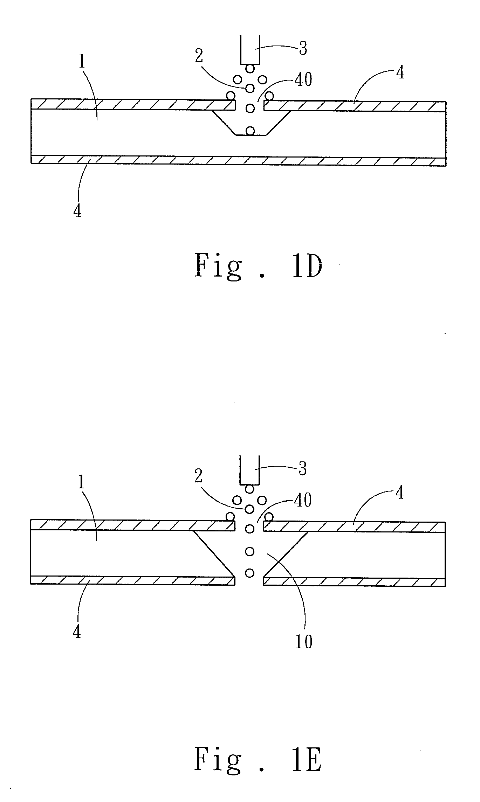

The solution 2 reaches the surface of the targeted object 1 to dissolve the insulator and continuously flows in through the opening 40. As a result fresh solution 2 (without containing the dissolved insulator) enters to hit and replace the used solution 2 contained the dissolved insulator. Therefore the surface of the targeted object 1 is consumed to form a hole desired (referring to FIG. 1D). While the dissolution caused by the solution 2 takes places, dissolution also occurs transversely (relative to the vertical incident direction of the solution 2). Hence the hole also is gradually and transversely enlarged as shown in FIG. 1D.

With the nozzle 3 and the targeted object 1 held stationary, and the solution 2 supplied and impact for a selected duration, the hole reaches the opposite surface of the targeted object 1 as shown in FIG. 1E. Then the hole drilling process can be stopped. The hole 10 thus formed has a trapezoidal cross section in the incident direction of the solution 2. The hole has a larger opening at the incident side of the solution 2 and a smaller opening (called emission opening hereinafter) at the opposite side. Moreover, the cross section of the hole 10 on planes perpendicular to the incident direction of the solution 2 is formed circular.

Furthermore, the opening areas around the hole 10 at the incident side and emission opening side still have a residual protection layer 4 which can be removed through a cleansing liquid in a cleansing process after the hole drilling process is finished. The protection layer 4 formed on the emission opening side may also be removed at the final stage of the hole drilling process by hitting with the solution 2.

The method for forming holes on insulators previously discussed is accomplished through a chemical reaction resulting from dissolution of the solution 2 rather than through physical action generated by impact of granular sands of the conventional sand blasting process. Hence the circumference of the resulting hole 10 is smoother and more appealing without forming an uneven surface. Moreover, the embodiment of the method previously discussed also provides physical impact through ejection of the solution 2 so that the used solution 2 on the surface of the targeted object 1 can be replaced as desired, and a cutting effect also can be accomplished through the impact. Namely, the insulator can be softened through contact with the solution 2, and physical bouncing can be generated due to impact of the ejecting solution 2.

In the method set forth above, a surface active agent may be added to the solution 2 to accelerate movement of the dissolved solution on the surface of the targeted object 1 and facilitate replenishment of the solution. The surface active agent may be selected from the group consisting of fluoride. The amount of the surface active agent to be added is about 0.1 to 0.5% by weight of the total diluted solution.

In another aspect, the particle size of the solution 2 is preferably smaller than the opening 40. If the particle size were greater than the opening 40, the opening 40 could be clogged, and surface tension could hinder flowing of the solution 2.

Please refer to FIG. 3 for an embodiment of the image detection device module of the invention. It includes a detection element 51 and an optical window 52 made from an insulator and located on an incident side of the detection element 51. The detection element 51 may consist of CMOS or CCDs.

The module has a ceramic substrate 53 and a frame 54 to cover the substrate 53. The frame 54 has an opening on an upper surface to hold the optical window 52. The substrate 53 has a circuit 55 to couple with the detection element 51 and process signals of the detection element 51. The substrate 53 further contains peripheral elements such as capacitors or resistors not marked in the drawings. In order to shrink the module the substrate 53 is generally formed in multiple layers each embedded with a circuitry.

The optical window 52 holds a micro-lens 56 to project light to the detection element 51 to capture a wide angle image of an object. The micro lens 56 may be a non-spherical lens made from plastics.

The optical window 52 preferably provides infrared light filtering function. It may be made from an insulator capable of filtering the infrared light, or have the surface bonded to a film capable of filtering the infrared light. Such an image detection device module now is available on the market, such as product model LZOP3908 made by SHARP Co. Moreover, a transparent cover may be provided on the incident side of the optical window 52 to guard the micro-lens 56 from exposing.

The optical window 52 is fabricated on a plate-shaped material made from the insulator by a hole drilling process substantially like the one previously discussed, such as by dissolving the insulator with the solution 2 formed with particles at diameters between 20µm and 400µm and ejected through the nozzle 3 to a drilling spot of the shaped material. The particulate solution is ejected at a pressure between 5X10⁻²N/cm² and 20X10⁻² N/cm² to continuously hit the drilling spot to form a window opening for the optical window 52.

Referring to FIG. 3, the optical window 52 has an orifice 520 formed in a trapezoidal cross section along an optical axis A, with a larger size on the incident side and a smaller size on the emission side. The orifice 520 has circular cross sections perpendicular to the optical axis A.

Also referring to FIG. 3, the orifice 520 has a circumferential surface 521 forming an included angle (called circumferential angle hereinafter) of 45 degrees with the optical axis A. The circumferential angle may be varied according to the characteristics of the micro-lens 56 or the detection element 51, but generally is set at 45 degrees.

Compared with the optical window 52 fabricated through the conventional sand blasting approach, the optical window 52 thus formed has significant differences as follow:

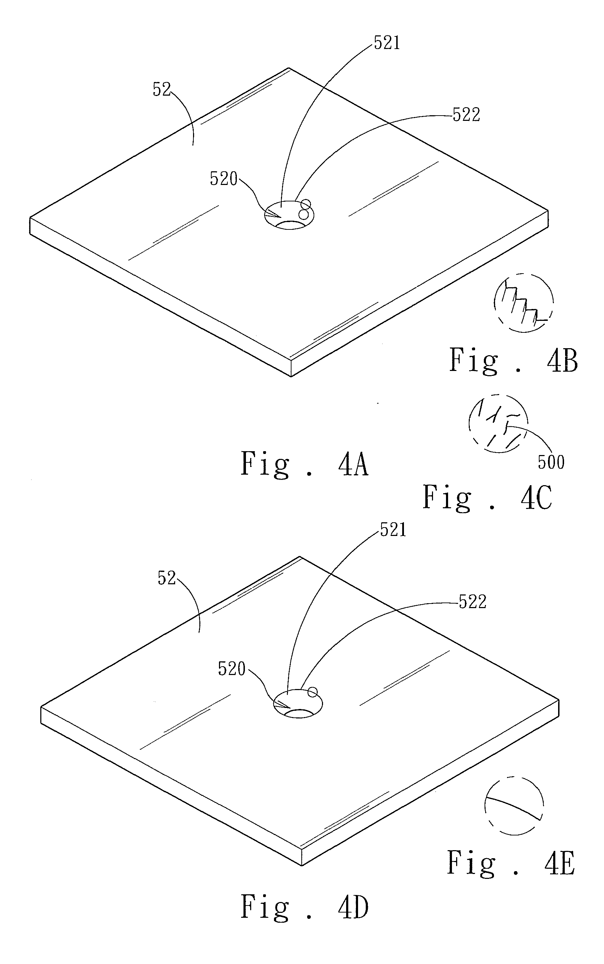

Refer to FIGS. 4A through 4E for an embodiment of the optical window 52 used on the image detection device module, to facilitate comparison the structure of the optical window 52 fabricated through the conventional sand blasting approach also is incorporated. FIG. 4A illustrates the optical window 52 fabricated through the conventional sand blasting approach. FIGS. 4B and 4C are fragmentary enlarged views according to FIG. 4A. FIG. 4D illustrates the optical window 52 used in the embodiment of the image detection module of the invention. FIG. 4E is a fragmentary enlarged view according to FIG. 4D.

Referring to FIGS. 4A and 4B, the conventional optical window 52 formed by the sand blasting approach has an uneven perimeter 522 or circumferential surface 521 around the orifice 520 and results in an undesired appearance. By contrast, on the optical window 52 according to the embodiment of the invention, referring to FIGS. 4D and 4E, the perimeter 522 or circumferential surface 521 around the orifice 520 are smooth without forming an uneven surface.

Also referring to FIG. 4C, the optical window 52 fabricated through the conventional technique often has small cracks 500 caused by scratches or cracks formed on the surface of the insulator. This is created in fabrication process of the insulator and not avoidable. The small cracks 500 result in a lower strength of the insulator. In the sand blasting process to fabricate the optical window 52 a great number of small cracks 500 are formed on the circumferential surface 521 caused by scraping of the solid sands. The number of the cracks 500 increases significantly after the fabrication process of hole drilling. Aside from damaging the appearance, these cracks 500 cause significant decrease of strength.

By contrast, the optical window 52 according to the embodiment of the invention does not produce small cracks because it is formed by dissolving of the solution 2. The cracks that are originally formed on the insulator surface during the fabrication process also can be eliminated due to dissolving of the solution 2. Thus a smooth surface without cracks can be formed to enhance the strength.

In another aspect during fabricating the optical window 52 the protection layer 4 may also be retained without being removed after the hole is formed. For instance, for the protection layer 4 which is a light mask having optical filtering effect can protect the insulator during hole drilling process, and provide filter function for the optical window 52 in the finished product. For one that also serves as a filter, it may provide a function to filter out infrared light. In the event that the protection layer 4 is a chromium sheet, a residual chromium sheet may be maintained to filter out infrared light or the like.

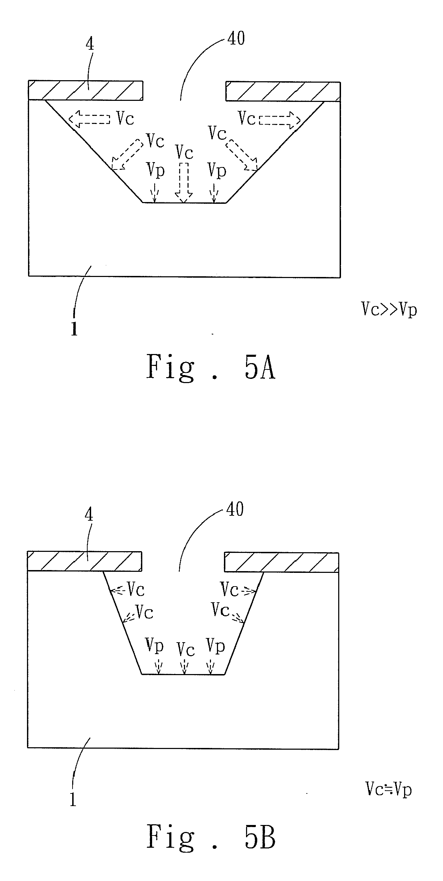

The invention also provides a method to adjust the circumferential angle of the optical window 52. Refer to FIG. 3 for an embodiment of this method. The circumferential angle in this embodiment is 45 degrees. Other circumferential angles may also be adjusted by a desired hole drilling process. FIGS. 5A and 5B illustrate the schematic views of such a process.

As previously discussed, during the hole drilling process chemical reaction and physical action occur. The chemical reaction provides dissolution through the solution 2, hence is astatic and takes place uniformly. The physical action is caused by impact of the solution 2 on the insulator surface, hence takes place in the impact direction. As shown in FIGS. 5A and 5B, assumed that the dissolving speed of the insulator caused by the chemical reaction is Vc, and the consuming speed of the insulator caused by the physical action is Vp, Vc and Vp indicate the speed of dissolving or consuming of the thickness in a unit time.

Referring to FIGS. 5A and 5B, due to the dissolution of the chemical reaction takes place uniformly, Vc is substantially evenly distributed in the recess during the hole drilling process. On the other hand, the physical action is caused by the consuming process and takes place substantially in the ejecting direction of the solution 2, hence Vp is maximum at the bottom of the recess but is substantially negligible on other portions.

Hence when Vc > > Vp, namely when Vp is much smaller than Vc, and Vp is substantially zero, merely the dissolution caused by the chemical reaction has substantial effect. And hole drilling can be executed evenly. In such a condition, as shown in FIG. 5A, the resulting circumferential angle of the hole 10 is about 45 degrees.

When the condition of Vc > > Vp does not exist, hole drilling is executed in an astatic fashion, and is faster at the bottom of the recess. For instance, when Vc= Vp, the hole drilling speed at the bottom of the recess is about twice than on the lateral sides of the recess. Then the resulting circumferential angle of the hole 10 is about 20-25 degrees.

Thus by adjusting the relative amount of Vp and Vc the circumferential angle can be altered. Vc also is greatly affected by the ingredient concentration of the solution 2, while Vp is largely determined by the impact pressure of the solution 2. When the impact pressure increases, Vp is faster. This also makes replenishment speed of the solution 2 on the surface faster, hence Vc also becomes faster. But the effect of increasing the impact pressure is greater than the effect of increasing the replenishment speed. As a result Vp is greater than Vc. Thus the circumferential angle becomes smaller. In another aspect, with an increased impact pressure, when the concentration of the solution 2 decreases, Vp can be made faster than Vc. Hence such an adjustment approach may also be adopted. Anyway, the concentration and impact pressure of the solution 2 needed to form a required circumferential angle have to be calculated in advance by trials, then the hole drilling process is performed in a reconstructed condition.

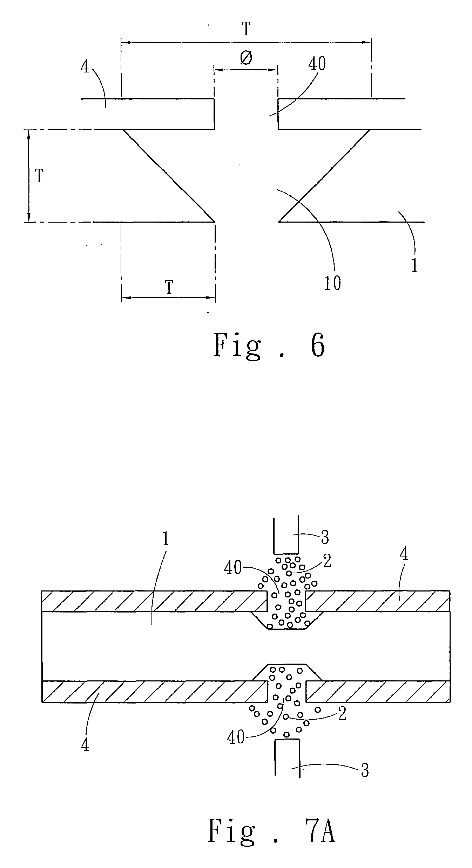

Refer to FIG. 6 for the relationship between the opening shape of the hole 10 and the size of the opening 40. In the embodiment of the method for drilling holes on insulators previously discussed, the hole is formed by supplying the solution 2 in the opening 40 of the protection layer 4. The size of the opening 40 is determined according to the relationship with the opening size on the incident side of the hole 10 where the solution 2 enters. Assumed the diameter of the opening on the incident side is R, the diameter of the opening 40 is ψ, and the thickness of the targeted object 1 is T. As the concept of "thickness" sometimes is difficult to apply because of the shape of the target object 1, it is treated as "the distance to be run through to form the hole 10" in the following discussion.

Referring to FIG. 5A, in the condition of Vc > > Vp, and the circumferential angle is 45 degrees, hole drilling is executed in an astatic fashion. In such a condition, while a hole of the thickness T is formed through the solution 2 in an impact condition, the opening on the incident side also forms by dissolution a distance T transversely. Hence after the hole drilling process is finished the diameter of the opening on the incident side becomes ψ +2T As shown in FIG. 6, with the opening on the incident side formed at the size of R, the opening 40 at the size of ψ, a relationship of ψ = R-2T is established. And the size of the opening on the incident side is same as the opening 40 for hole drilling.

Thus taken an example to adjust the circumferential angle of 45 degrees in the condition of Vc > > Vp, the adjustment can be performed easily and the reproducibility is high. Namely, treating the size of the opening as R-2T. It is a simple and effective process.

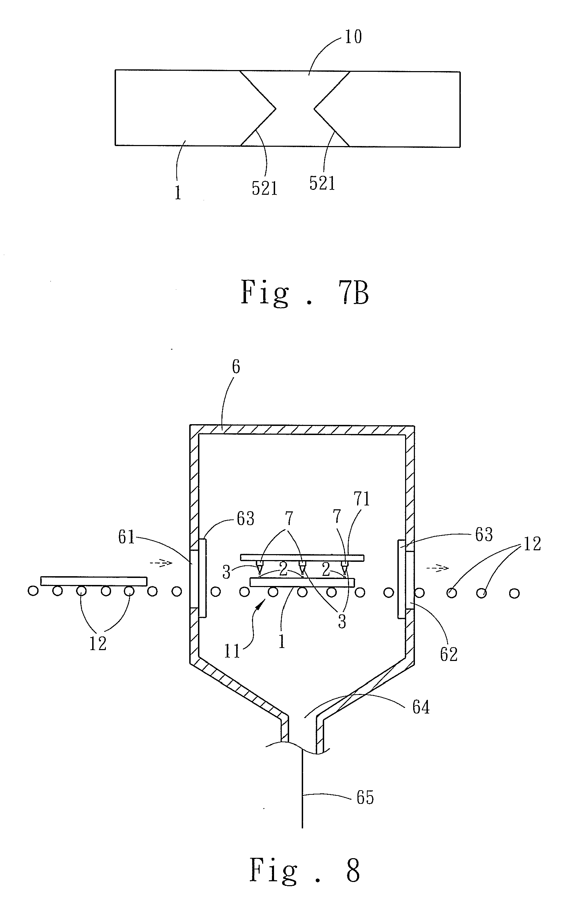

Please refer to FIGS. 7A and 7B for a second embodiment of the method for drilling holes on insulators. In this embodiment the solution 2 is ejected to impact the targeted object 1 at two sides simultaneously and continuously to form the hole 10.

The protection layer 4 covers two sides of the targeted object 1 with an opening 40 for hole drilling formed respectively thereon. The thickness or material of the protection layer 4, and the size or forming method of the opening 40 are same as the embodiment previously discussed. As shown in FIGS. 7A and 7B, the solution 2 is ejected at two sides to hit the targeted object 1 to form the hole 10. The hole 410 has a circumferential surface 521 formed therein jutting inwards as shown in FIG. 7B.

In this method the hole is formed by dissolving of the solution 2, hence the perimeter is smooth without unevenness. As the solution 2 is ejected to hit the targeted object 1 at two sides to form the hole, compared with the method shown in FIGS. 1A through 1E, the time required to do hole drilling is reduced to one half. Thus productivity increases.

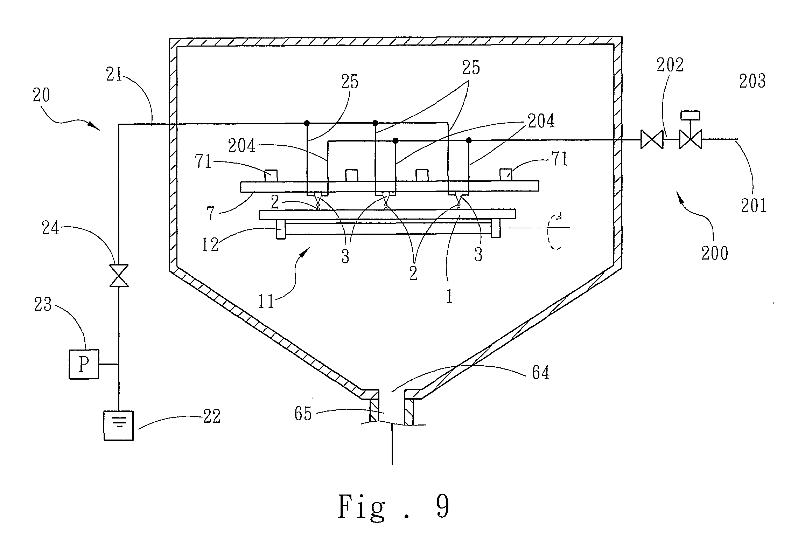

Please refer to FIGS. 8 and 9 for an embodiment of the apparatus for drilling holes on insulators. It aims to fabricate the holes on the insulators by adopting the method shown in FIGS. 1A through 1E.

The apparatus shown in FIGS. 8 and 9 includes a nozzle 3 to eject the solution 2 to form particles at diameters between 20µm and 400µm, a solution supply system 20 to deliver the solution 2 to the nozzle and a targeted object holding mechanism 11 to hold the targeted object 1 so that the solution 2 can be ejected to the drilling spot of the targeted object 1.

The solution 2, as previously discussed, may be fluorinate acid diluted to a selected concentration. The nozzle 3 is formed in the same way as shown in FIG. 2. In this embodiment a plurality of nozzles 3 are provided in a processing chamber 6 to fabricate the hole.

In this embodiment the targeted object 1 is a shaped plate (a plate type insulator) held by the targeted object holding mechanism 11 which also carries the targeted object 1 into the processing chamber 6, and carries the targeted object 1 out of the processing chamber 6 after the hole is formed.

The processing chamber 6 has a transport inlet 61 to receive the targeted object 1 and a transport outlet 62 to allow the targeted object 1 to be moved out. The transport inlet 61 and transport outlet 62 are closed respectively by a sealing gate 63. Opening and closing of the inlet and outlet are accomplished by moving the sealing gate 63 upwards and downwards.

Referring to FIG. 8, a transport mechanism is provided to continuously transport the targeted object 1 horizontally. The transport mechanism has a plurality of transport rollers 12 located horizontally on the transport route. The transport route is set between the transport inlet 61 and the transport outlet 62. The targeted object 1 is moved in through the transport inlet 61 to be drilled and moved out through the transport outlet 62.

The processing chamber 6 has inner wall surfaces which are medicine-resistant. There are varying types of processing elements held in the processing chamber 6 that also have medicine-resistant surfaces. For instance, in the event that the solution 2 is fluorinate acid the surfaces of the inner wall or elements may be coated with a fluoride resin such as Teflon (a trademark of DuPont Co.). Moreover, the sealing gate 63 aims to seal the transport inlet 61 and transport outlet 62 to confine the solution 2 without leaking.

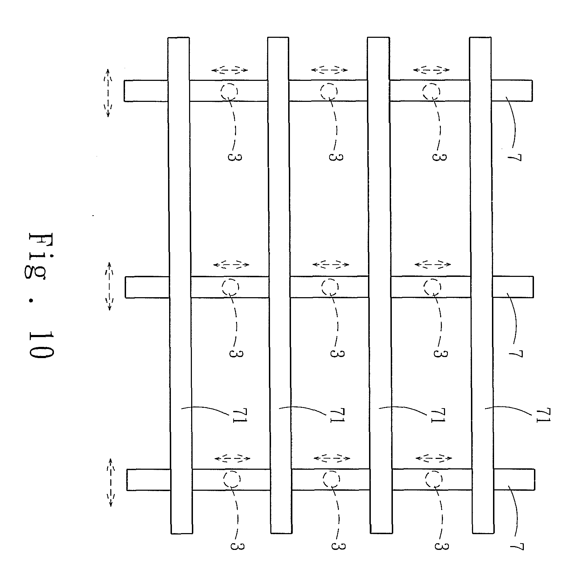

The nozzle 3 is held by a nozzle holder 7. Refer to FIG. 10 for the nozzle holder 7 used in FIGS. 8 and 9. In this embodiment the nozzle 3 is movable in any position on a horizontal plane to dill holes at any position desired.

More specifically, the nozzle holder 7 is formed in rails to allow the nozzle 3 to be moved and positioned in any longitudinal location. The nozzle holder 7 has multiple sets positioned on the same horizontal plane in a juxtaposed manner.

There is a holder rail 71 located above the nozzle holder 7. The holder rail 71 is a guiding track and also contains multiple sets positioned on a same horizontal plane in a juxtaposed manner. The holder rail 71 is extended in a direction perpendicular to the extending direction of the nozzle holder 7. Namely, as shown in FIG. 10, each nozzle holder 7 and each holder rail 71 cross each other vertically in a grid fashion.

The nozzle holder 7 is installed on a lower surface of the holder rail 71 and movable in the extending direction of the holder rail 71 to be anchored on any location desired.

Referring to FIG. 9, the solution supply system 20 of the apparatus aims to supply the solution 2 to each nozzle 3. The apparatus also includes a compressed air supply system 200 to supply compressed air to each nozzle 3. The solution supply system 20 includes a solution supply tube 21 to deliver the solution 2 to each nozzle 3. The solution supply tube 21 runs through the wall of the processing chamber 6. The solution supply system 20 also has a liquid tank 22 to hold the solution 2 and a liquid delivery pump 23 and a regulation valve 24 to deliver the solution 2 through the solution supply tube 21 to each nozzle 3. In addition, in the event that a surface active agent is added to the solution 2, it is added in advance in the liquid tank 22, or a surface active agent mixer is added to the liquid supply tube 21. The compressed air supply system 200 include a compressed air supply tube 201 connecting to a compressed air tank (not shown in the drawings), or an open/close valve 202 on the compressed air supply tube 201 and a regulation valve 203.

The solution supply tube 21 and nozzle 3, and compressed air supply tube 201 and nozzle 3 are connected respectively through hoses 25 and 204 to facilitate position alteration of the nozzle 3.

Also referring to FIGS. 8 and 9, the processing chamber 6 has a bottom formed in a funnel shape with a discharge port 64 at the bottom. The discharge port 64 is coupled with a discharge duct 65 to discharge used solution 2. The used solution 2 contains dissolved material from the surface of the targeted object 1 and drops to the bottom of the processing chamber 6, and is discharged through the discharge port 64 and discharge duct 65.

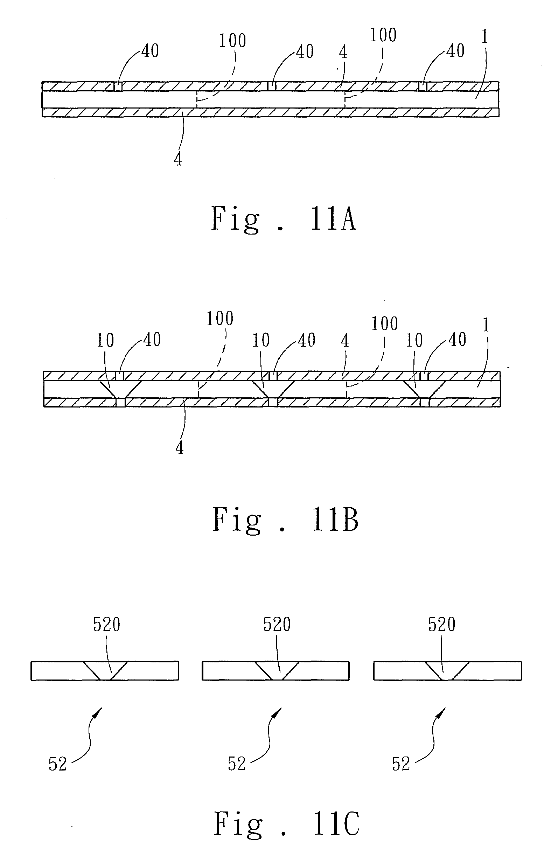

Refer to FIGS. 11A, 11B and 11C for the processes of the apparatus depicted in FIGS. 8 and 9 to drill holes on a targeted object. The image detection device module has an optical window 52 located thereon with an orifice 520 formed on a small plate type element. To fabricate such an element, a larger plate type material is used as a targeted object 1 and holes are formed thereon at drilling spots through a hole drilling process. Then the targeted object 1 is cut off to become finished products. This approach is desirable for mass production. FIGS. 11A through 11C illustrate such an approach, in which broken lines 100 indicate the cutoff lines of the targeted object 1.

Referring to FIG. 11A, a protection layer 4 is formed to protect the external and internal surfaces of the targeted object 1. Openings 40 for hole drilling are formed on the surface of the protection layer 4 where drilling operation is to be executed. The protection layer 4 may also be formed at other positions according to requirements (such as end surfaces and the like of the targeted object 1). Referring to FIG. 8, the targeted object 1 is carried through the transport mechanism into the processing chamber 6 and held at the drilling spot. The nozzles 3 in the processing chamber 6 are located above the openings 40 at preset corresponding positions to facilitate hole drilling operation. The positions can be adjusted as previously discussed, by anchoring the nozzle holder 7 on the holder rail 7 to keep the nozzles 3 held thereon to be positioned at the drilling spots.

In such a condition, referring to FIG. 8, the solution 2 can be ejected through the nozzle 3 to hit the surface of the targeted object 1 through the opening 40 for a selected time period to form the hole required (also referring to FIG. 11B). Next, remove the protection layer 4 through a cleansing process as required. Then the targeted object 1 is cut off along the cutoff line 100. Finally other necessary processes such as removing rough edges are performed to get finished products (optical windows) (referring to FIG. 11C). As previously discussed, in some occasions the protective layer 4 may be retained without being removed for some specific purposes.

By means of the apparatus set forth above the holes on the insulators can be formed through the solution 2 by dissolving. The holes 10 thus formed do not have uneven circumferences and are more aesthetic appealing. Moreover, multiple nozzles 3 can be deployed to drill multiple holes at the same time. Thus it is suitable to fabricate multiple products by working on a large piece of the targeted object 1.

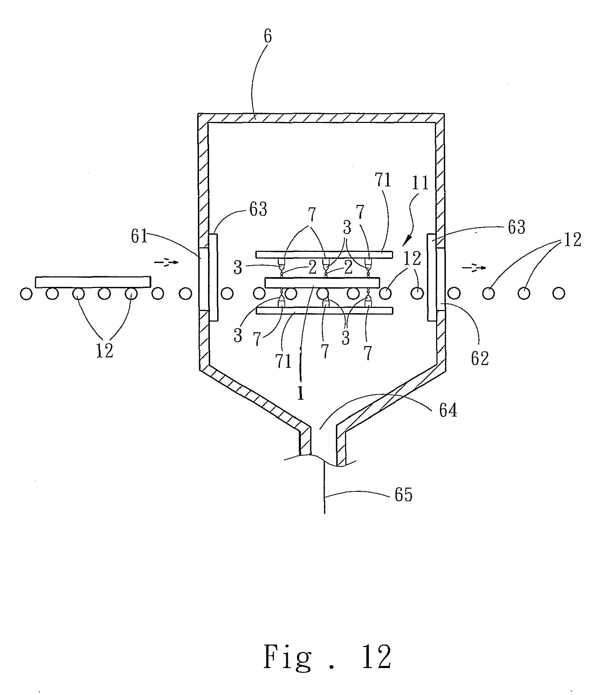

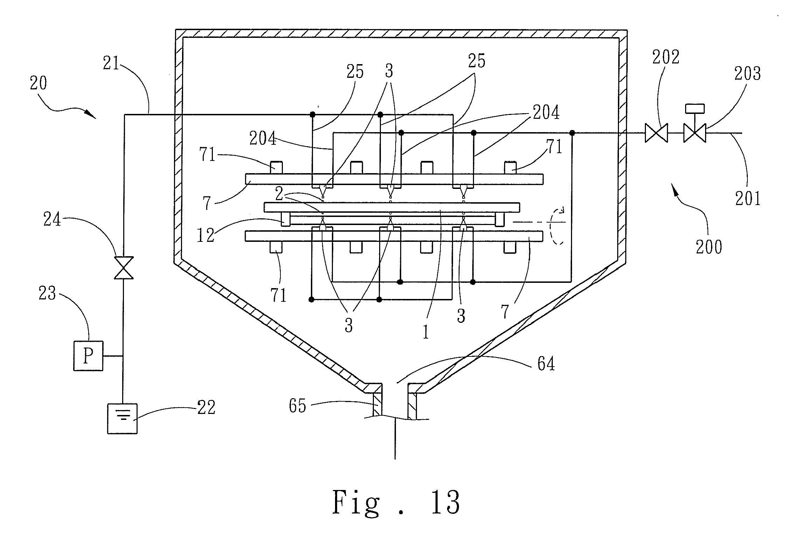

Refer to FIGS. 12 and 13 for a second embodiment of the apparatus for drilling holes on insulators according to the invention. It aims to use the method depicted in FIGS. 7A and 7B to do hole drilling process. Namely with the nozzles 3 deployed at two sides of the targeted object 1 to eject the solution 2 from two sides.

The apparatus, aside from having the nozzles 3 located at a lower side of the transport production line of the transport mechanism, other structures and features are substantially same as those shown in FIGS. 8 and 9. Multiple sets of the nozzles 3 are provided at the lower side. These nozzles are installed on the nozzle holders 7 and adjustable in terms of positions. The positions of the nozzle holders 7 also are alterable through the holder rails 71. The nozzles 3 at the lower side also are connected respectively to the solution supply tube 21 and compressed air supply tube 201 through hoses 25 and 204.

When the apparatus shown in FIGS. 12 and 13 is used for drilling holes, the surfaces at two sides of the targeted object 1 also are covered by a protection layer 4 to form openings 40 for hole drilling process. The openings 40 also are formed on the protection layer 4 on inner sides. Once the targeted object 1 is moved into the processing chamber 6 and held stationary at the drilling spot, the openings 40 are located on the vertical line positions linking the upper and lower nozzles 3. In such a condition the solution 2 and compressed air are supplied to each nozzle 3 to do hole drilling process. The upper and lower nozzles 3 are adjusted in advance to be positioned on the same vertical line.

By means of the apparatus mentioned above holes with a smooth circumference can be formed. As the holes are formed at two sides, drilling operation can be finished in a shorter time period. Moreover, same impact pressure are exerted to the two sides of the targeted object 1, hence the ejection pressure of the solution 2 from the nozzles 3 at the lower side is greater than that of the upper side.

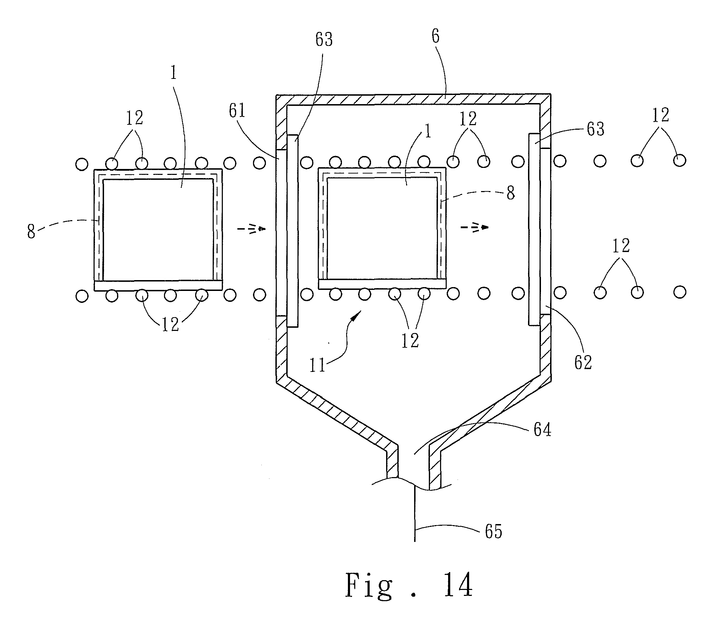

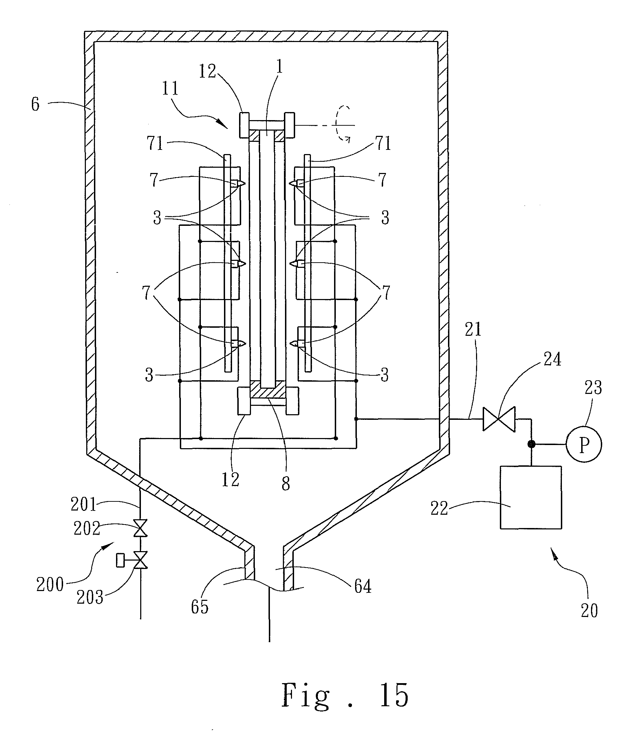

Refer to FIGS. 14 and 15 for a third embodiment of the apparatus for drilling holes on insulators according to the invention. It aims to drill holes on an assumed plate type targeted object 1 positioned in an upright manner.

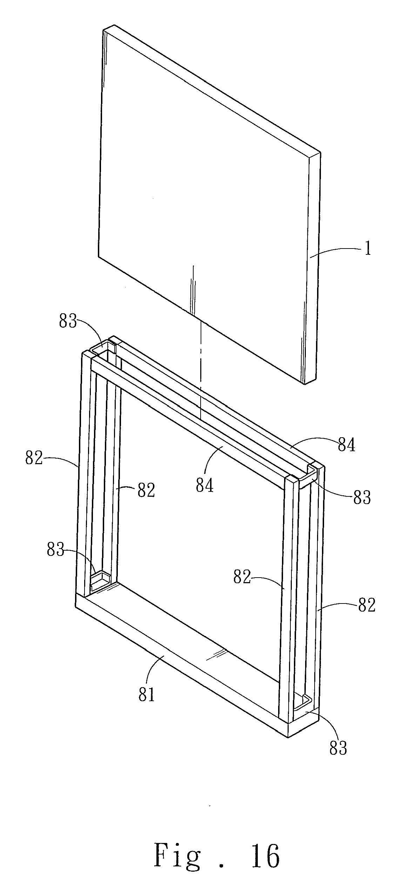

In the third embodiment the hole drilling process also is performed in the processing chamber 6. It has a targeted object holding mechanism 11 to carry the targeted object 1 into the processing chamber 6 for processing and carry the targeted object 1 out after the hole drilling process is finished. As the targeted object 1 is held in an upright manner the transport mechanism has a special holder (called targeted object holder hereinafter) 8 to do transport. FIG. 16 illustrates an embodiment of the targeted object holder 8.

Referring to FIG. 16, the targeted object holder 8 aims to hold the targeted object 1 at a substantially upright position. It mainly includes a horizontal base plate 81, bracing struts 82 mounting onto the base plate 81 in an upright manner and a buffer element 83 installed on the bracing struts 82.

The bracing struts 82 include four pieces and are mounted onto the corners of the rectangular and elongate base plate 81. There is a beam 84 located in a longitudinal direction of the base plate 81 to connect upper ends of the bracing struts 82 to reinforce the targeted object holder 8. The bracing struts 82 are slighting higher than the targeted object. Two of the bracing struts 82 are anchored on each of two shorter sides of the base plate 81 and spaced from each other to form an interval slightly greater than the thickness of the targeted object 1. As a result, another two bracing struts 82 are spaced from each other on a longer side of the base plate 81 to form another interval which is slightly greater than the length of the targeted object 1. Thus a space is formed with the bracing struts 82 serving as borders to allow the targeted object 1 to be wedged inside.

The buffer element 83 is in direct contact with the targeted object 1 to hold it firmly without wobbling. The buffer element 83 is made from a corrosion-resistant (medicine resistant) material, such as a fluoride resin like Teflon (a trademark of DuPont Co.).

Referring to FIG. 16, the buffer element 83 bridges two lower ends of the bracing struts 82 in the longitudinal direction of the base plate 81, and also bridges two upper ends of the bracing struts 82 in the longitudinal direction of the base plate 81. Each of the corners of the targeted object 1 is in contact with the buffer element 83. The buffer element 83 at the lower side to be in contact with the lower corner of the targeted object 1 is formed with an indented cross section at the shorter side, while a L-shaped cross section is formed at the longer side thereof. The buffer element 83 to be in contact with the upper corner of the targeted object 1 has a shorter side cross section formed in a transverse indented manner. Thus, as shown in FIG. 14, the targeted object 1 can be slid from an upper side in the indented portions of the buffer elements 83.

The transport mechanism provided in this embodiment to carry the targeted object 1 includes transport rollers 12. Referring to FIGS. 14 and 15, the transport rollers 12 are located at an upper side and a lower side to clip and transport the targeted object holder 8 at the same time. Namely, the transport rollers 12 have axes rotating horizontally, and are spaced from each other in the height direction of the targeted object holder 8. Multiple transport rollers 12 are provided and spaced from one another according to a transport and production line, and driven by a driving source not shown in the drawings. Thus the targeted object holder 8 can be moved horizontally to transport the targeted object.

Each of the transport rollers 12 has an axle formed at a length slightly longer than the thickness of the targeted object holder 8. Referring to FIG. 13, the transport rollers 12 also form a step through the axle and rollers to confine the edge of the targeted object holder 8 to make transport movement steadier.

By means of the apparatus in this embodiment the solution 2 is ejected at two sides of the targeted object 1 to do hole drilling process. Namely, as shown in FIG. 15, the nozzles 3 are located at two sides of the transport and production line. In FIG. 14 the nozzles and nozzle holder are omitted.

In this embodiment multiple nozzles 3 are provided. Referring to FIG. 15, the nozzles 3 are positioned on the same upright plane at two sides. The ejection opening of the nozzles 3 is directed horizontally to eject the solution 2 perpendicular to the surface of the targeted object 1 (namely the transport direction of the targeted object 1 in this embodiment). Namely, the line linking the openings of the nozzles 3 at two opposing sides is horizontal but perpendicular to the transport direction. The nozzles 3 at the two opposite sides are spaced from the targeted object 1 at a same distance.

In this embodiment the positions of the nozzles may also be adjusted. Each of the nozzles 3 is installed on the upright nozzle holder 7, and multiple nozzle holders 7 are held on the holder rail 71. Aside from making the former horizontal objects upright, other structures are substantially same as those shown in FIG. 10.

Operation of the third embodiment of the apparatus for drilling holes on insulators is elaborated as follow:

Similar to those discussed previously, the targeted object 1 also has a protection layer 4 and an opening 40 for hole drilling formed thereon as shown in FIG. 16, and is held by the targeted object holder 8 and carried by the transport mechanism into the processing chamber 6 and stationed at the drilling spot on which the opening 40 is located on the ejection line of the nozzles 3.

While the targeted object 1 is held at the position previously discussed, the solution 2 and compressed air are supplied and delivered to the nozzles 3 to be ejected to hit the surface of the targeted object 1 to perform hole drilling process. The ejection pressure of the solution 2 through the nozzles 3 on the two sides is same. After the hole drilling operation is finished, the targeted object holder 8 is moved out from the processing chamber 6 to remove the targeted object 1.

In this embodiment the hole is formed by dissolving of the solution 2, thus the circumferential of the hole is smooth without forming uneven surface. As the solution 2 is ejected at two sides of the targeted object to do hole drilling process, the hole can be formed quickly. Since the targeted object 1 is held upright and the nozzles 3 at two sides are spaced from the targeted object at the same distance to eject the solution 2 at the same pressure, the hole can be formed evenly from the two sides.

The embodiment previously discussed that keeps the targeted object 1 in an upright condition during hole drilling process is especially desirable for an object difficult to be maintained in a horizontal condition, such as a large size LCD or plasma display panel used on a large flat screen display device. Many of those products are fabricated through a large insulator substrate 53 which tends to warp when held in a horizontal condition. Hence to keep the horizontal position and perform hole drilling at the same time are difficult. The third embodiment which maintains the upright condition during the hole drilling process offers a great advantage.

Furthermore, the targeted object holder 8 may also be dispensed with in the apparatus of the third embodiment. In such a situation the targeted object 1 is directly carried by the rollers and stationed at the drilling spot while the hole drilling process is performed. However, the targeted object holder 8 can keep the targeted object 1 from direct contact with the transport rollers, thus is less likely to damage the targeted object 1.

Regarding transport, aside from the transport rollers, gear racks and pinions may also be used to meet the same purpose. In such a condition, a gear rack is disposed on a lower surface of the targeted object holder 8, and multiple numbers of pinions are positioned in a spaced manner in the transport direction. Through rotation of the pinions the targeted object holder 8 can be moved horizontally.

In the apparatus of the third embodiment the nozzles 3 may also be positioned at a single side of the targeted object 1 to eject the solution 2 to perform holing drilling process.

In the embodiments set forth above, the targeted object 1 is a plate or plank, but this is not the limitation of the invention. It may also be a bar, sphere or other shapes to be drilled to form the holes.

While the embodiments previously discussed have a protection layer 4 with the opening 40 formed thereon to facilitate hole drilling process, the protection layer 4 may also be dispensed with. When the particles of solution 2 are formed at a smaller size and the nozzle is positioned closely to the location where the hole is formed by in contact with the solution 2, the protection layer 4 can be omitted. In such a condition, the solution 2 drips slowly to the drilling location on surface of the targeted object 1 without flowing to form the hole desired. In the event that the nozzle 3 is positioned at a lower side to eject the solution 2 upwards to do drilling, the solution 2 can be easily controlled to contact merely the drilling location.

The nozzle 3 of the invention may also be adapted to become a dual-fluid nozzle to eject the solution 2 through gas other than air (such as an inertia gas like nitrogen).

The solution, aside from fluorinate acid, may be other types of liquid as long as they can dissolve the insulator, for instance a liquid formed by diluting a strong acid such as sulfuric acid, and not limited to a diluted strong acid.

The method for drilling holes on insulators and the apparatus thereof of the invention may also be adapted to applications other than fabrication of the optical window 52 previously discussed, such as drilling a hole in the center of a disk type substrate made from the insulator.

### Embodiment 1:

A targeted object made from an insulator of silicon borate at a thickness about 500µm and formed in a plate shape is used for drilling a hole thereon.

The surface of the targeted object is covered by a protection layer made of a chromium sheet at a thickness about 1500 A (Angstroms). An opening with a diameter about 2.2mm is formed in advance on the protection layer for drilling the hole. The solution for dissolution is formed by diluting fluorinate acid with pure water to a concentration about 10%. A surface active agent made from fluoride is added at about 0.3% by weight.

The solution is ejected by compressed air through a nozzle to become mist with particle diameters between 20µm ~ 200µm to hit the surface of the targeted object continuously at a pressure about 15X10⁻²N/cm² for a duration about 2400 seconds. The hole is formed with an opening on the incident side at a diameter about 3mm, and another opening on the emission side at a diameter about 2.2mm, and a circumference angle about 45 degrees.

## Claims

1. A method for drilling holes on insulators to form a micro-hole on a targeted object (1) made from an insulator, comprising the steps of:
ejecting a solution (2) capable of dissolving the insulator through a nozzle (3), the solution (2) containing particles at a size between 20µm and 400µm;
hitting a drilling spot of the targeted object (1) with the ejecting solution (2) at a pressure between 5X10⁻²N/cm² and 20X10⁻² N/cm²; and
forming a hole on the drilling spot of the targeted object (1) by continuously hitting with the particulate solution (2).

2. The method of claim 1, wherein the targeted object (1) is covered by a protection layer (4) on the surface thereof to prevent the targeted object (1) from being in contact with the solution (2), the protection layer (4) having an opening (40) for hole drilling corresponding to the drilling spot that is formed at a size greater than the solution particles so that the drilling spot of the targeted object (1) is in contact with the solution (2) through the opening (40) and dissolved to perform the hole drilling.

3. The method of claim 2, wherein the hole being formed has an opening at a diameter R on an incident side where the solution (2) enters while the targeted object (1) has a thickness T, the opening (40) for hole drilling being formed at a diameter equivalent to R-2T.

4. The method according to any of the preceding claims, wherein the nozzle (3) is a dual-flow nozzle to mix compressed air with the solution (2) before ejecting.

5. A method for fabricating an optical window made from an insulator to be located on an incident side of an optical element, said method using the method according to any of the preceding claims for drilling a hole into said optical window (52), said optical window (52) serving as said targeted object.

6. A method for adjusting an angle of an optical window circumferential surface (521) of an optical window (52) made from an insulator and located on an incident side of an optical element, the circumferential surface (521) forming an included angle with an optical axis (A) to become an intended angle, the optical window (52) having an opening on the incident side that is greater than another opening formed on an emission side of the optical window (52), the method comprising the steps of:
forming a protection layer (4) on a surface of a targeted object (1) on which the optical window (52) is formed;
forming an opening (40) for hole drilling on the protection layer (4) to perform hole drilling; and
using the method according to any of claims 1 to 4 to continuously hit a drilling spot on the targeted object (1) until the targeted objected (1) is run through to thereby drill a hole into said targeted object (1), the angle of the circumferential surface (521) of the optical window (52) being adjustable by altering the hitting pressure and ingredient concentration of the solution (2) while said hole is drilled to thereby adjust the angle of said optical window circumferential surface (521).

7. An apparatus for drilling holes on insulators to form a micro-hole on a targeted object (1) made from an insulator, comprising:
a nozzle (3) to eject a solution (2) to form particles at diameters between 20µm and 400µm to dissolve the insulator;
a solution supply system (20) to deliver the solution (2) to the nozzle (3); and
a targeted object holding mechanism (11) to hold the targeted object (1) at a drilling spot to allow the targeted object (1) to continuously receive the ejecting solution (2) at a hitting pressure between 5X10⁻²N/cm² and 20X10⁻² N/cm².

8. The apparatus of claim 7, wherein the targeted object (1) is covered by a protection layer (4) on the surface thereof to prevent the targeted object (1) from being in contact with the solution (2), the protection layer (4) having an opening (40) for hole drilling corresponding to the drilling spot that is formed at a size greater than the solution particles, the particles formed by the solution (2) ejected through the nozzle (3) being smaller than the opening (40) for hole drilling.

9. An image detection device module comprising a module body of a detection element (51) and an optical window (52) made from an insulator formed in a plate that is located on an incident side of the detection element (51); wherein a hole is formed is said optical window (52) using the method according to any of claims 1 to 6.

10. The image detection device module of claim 9, wherein the optical window (52) has a surface covered by a protection layer (4) resistant to the solution (2), the protection layer (4) being an optical filter having selected optical characteristics.
